# EUROPÄISCHE PATENTSCHRIFT

(11) **EP 0 564 007 B1**
(45) Veröffentlichungstag und Bekanntmachung des Hinweises auf die Patenterteilung: **08.04.1998**
(21) Anmeldenummer: 93109037.7
(22) Anmeldetag: 15.11.1988
(51) Int. Cl.: H01L 29/74, H01L 29/08, H01L 31/111

(54) **Thyristor mit reduzierter Kippspannung**
Thyristor with reduced break-over voltage
Thyristor à tension de retournement réduite

(30) Priorität: 20.11.1987 DE 3739394
(43) Veröffentlichungstag der Anmeldung: 06.10.1993
(62) Teilanmeldung aus: 88119042.5
(73) Patentinhaber: SIEMENS AKTIENGESELLSCHAFT, 80333 München (DE)
(72) Erfinder: Schulze,Hans-Joachim,Dr.Dipl-Phys., D-85521 Ottobrun (DE); Mitlehner,Heinz,Dr.Dipl.-Phys., D-80798 München (DE)

(56) Entgegenhaltungen:
- EP-A- 0 002 840
- EP-A- 0 080 044
- EP-A- 0 154 082
- EP-A- 0 157 207
- EP-A- 0 197 512
- JAPANESE JOURNAL OF APPLIED PHYSICS, SUPPLEMENTS 17TH CONF. ON SOLID STATE DEVICES AND MATERIALS August 1985, TOKYO JA Seiten 393 - 396 MAKOTO AZUMA ET AL. 'High-Current, High-Frequency Gate Turn-Off Thyristors with P+P- Anode Emitter Structure'
- Thyristor Design & Realization, P.Taylor pub. J.Wiley 1987 Seiten 176-6.
- Thyristoren, Reihe Halbleiter-Elektronik, Band 12
- Springer Verlag, 1979, Seite 64

## Beschreibung

Die Erfindung bezieht sich auf einen Thyristor nach dem Oberbegriff des Patentanspruchs 1.

Wird bei einem Thyristor eine zwischen seiner kathodenseitigen und anodenseitigen Elektrode angelegte, den Thyristor blockierende Spannung auf den Wert der sog. Kippspannung (break over voltage) erhöht, so erfolgt ein lokaler Durchbruch des pn- Übergangs, der die p-Basis von der n-Basis trennt und etwa parallel zu einer Hauptfläche des Halbleiterkörpers verläuft. Im allgemeinen tritt der Durchbruch an dem in der Seitenfläche des Thyristors liegenden Rand dieses pn-Übergangs auf. Zur Vermeidung eines solchen unkontrollierbaren und sehr oft zur Zerstörung des Thyristors führenden lokalen Durchbruchs ist es aus der EP-A-0 088 967 bekannt, den pn-Übergang zwischen der p-Basis und der n-Basis durch Bestrahlung mit einem Laserstrahl unterhalb des zentralen Zündkontakts des Thyristors mit einer die Dicke der n-Basisschicht verringernden Ausbuchtung zu versehen und damit bereits bei einer reduzierten Kippspannung einen kontrollierbaren Durchbruch herbeizuführen, der im Bereich der Ausbuchtung auftritt. Dieser kontrollierbare Durchbruch führt zu einer Überkopfzündung des Thyristors, bei der eine thermische Zerstörung wegen der reduzierten Kippspannung nicht eintritt.

Aus der Veröffentlichung von Peter Voss mit dem Titel "A Thyristor protected against di/dt-failure at breakover turn- on", Solid-State Electronics, 1974, Vol. 17, pp. 655 - 661, Pergamon Press, ist die Einstellung der Kippspannung eines Thyristor mit Hilfe einer lokalen Erhöhung der Dotierung in der n-Basis bekannt, bei dem ein Ausgangsmaterial mit einem entsprechenden Dotierungsprofil verwendet wird und bei dem die Feldstärke in der n-Basis lokal verändert wird.

Aus der europäischen Patentanmeldung mit der Veröffentlichungsnummer 0 154 082 A2 ist ein Gate tun-off-Thyristor bekannt, der einen Teilbereich des p-Emitters aufweist, der im lateralen Bereich eines Zündkontakts angeordnet ist und eine höhere Dotierungskonzentration aufweist als die übrigen Teile des p-Emitters. Die Dotierungskonzentration in den übrigen Teilen des p-Emitters, wie beispielsweise im lateralen Bereich der Kathodenelektrode, ist gegenüber einer Grunddotierungskonzentration in den übrigen Teilen des p-Emitters zu vermeiden.

Aus der europäischen Patentanmeldung 0 080 044 A3 ist eine Halbleiteranordnung bekannt, bei der der p-Emitter in der Nähe der n-Basis einen gegenüber dem p-Emitter höher dotierten Bereich aufweist, um die Elektroneninjektion aus diesem Bereich in zwischen dem p-Emitter und der n-Basis befindliche n⁺⁺-dotierte Bereiche zu verbessern.

Ein weiteres Bauelement ist in dem Dokument EP-A-157207 beschrieben.

Der Erfindung liegt die Aufgabe zugrunde, einen Thyristor der eingangs genannten Art anzugeben, bei dem der pn-Übergang zwischen der p-Basis und der n-Basis beim Erreichen einer Kippspannung in definierter Weise durchbricht, ohne daß hierdurch eine thermische Zerstörung eintritt. Das wird erfindungsgemäß durch eine Ausbildung nach dem kennzeichnenden Teil des Patentanspruchs 1 erreicht.

Der Anspruch 2 ist auf eine bevorzugte Weiterbildung der Erfindung gerichtet.

Die Erfindung wird nachfolgend anhand der Zeichnung näher erläutert. Dabei zeigen:
- Figur 1: ein erstes Ausführungsbeispiel der Erfindung und
- Figur 2: ein zweites Ausführungsbeispiel, während

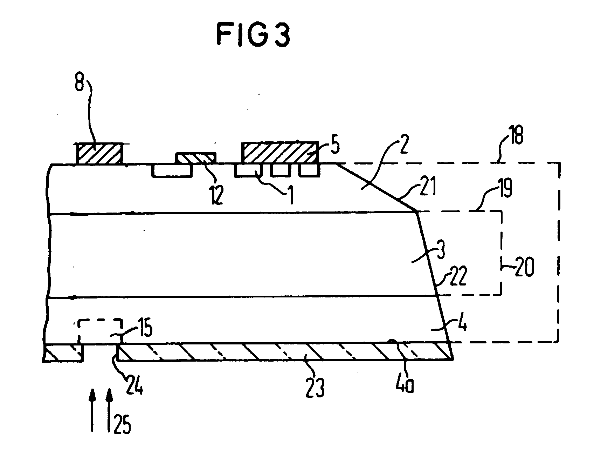

- Figur 3: ein bevorzugtes Verfahren zur Herstellung eines Thyristors nach Figur 1 oder 2 näher erläutert.

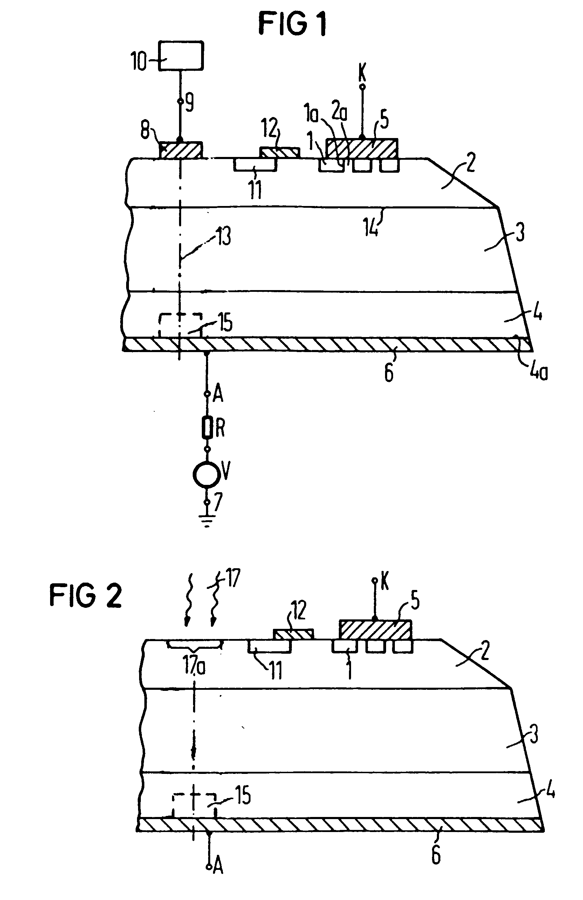

Figur 1 zeigt einen Leistungsthyristor, der einen dotierten Halbleiterkörper mit vier aufeinanderfolgenden Halbleiterschichten alternierender Leitfähigkeitstypen aufweist. Im einzelnen bestehen diese aus einem n-Emitter 1, einer p-Basis 2, einer n-Basis 3 und einem p-Emitter 4. Der n-Emitter 1 wird von einer mit einem Anschluß K versehenen, kathodenseitigen Elektrode 5 kontaktiert, der p-Emitter 4 von einer anodenseitigen Elektrode 6, die mit einem Anschluß A versehen ist. Ein bei A angeschlossener äußerer Stromkreis besteht aus einem Arbeitswiderstand R und einer in Serie zu diesem liegenden Spannungsquelle V, die z.B. eine Gleichspannung von 1000 Volt abgibt. Der nicht mit R beschaltete Anschluß der Spannungsquelle V, der mit 7 bezeichnet ist, liegt ebenso wie der Anschluß K auf Bezugspotential. Dabei wird die anodenseitige Elektrode 6 durch die von V gelieferte Spannung auf ein gegenüber K positives Potential gelegt, so daß sich der Thyristor im sog. blockierenden Zustand befindet.

Ein die p-Basis 2 kontaktierender Zündkontakt 8 ist mit einem Anschluß 9 versehen, dem aus einem mit 10 bezeichneten Zündstromkreis ein positiver Spannungsimpuls zugeführt wird, um den Thyristor zu zünden. Wird der sich im blockierenden Zustand befindende Thyristor durch die Zündung in den stromführenden Zustand übergeführt, so schließt er den äußeren, über A, R, V, 7 und K verlaufenden Stromkreis durch eine niederohmige Verbindung von K und A. Das Löschen des Thyristors, d.h. seine Überführung in den hochohmigen, nicht stromführenden Zustand erfolgt durch Abschaltung der Spannungsquelle V oder für den Fall, daß es sich bei V um eine Wechselspannungsquelle handelt, bei dem ersten nach der Zündung auftretenden Nulldurchgang der von V gelieferten Wechselspannung.

Ein in die p-Basis 2 eingefügtes n-leitendes Gebiet 11 ist mit einer leitenden Belegung 12 versehen, die in Richtung auf den n-Emitter 1 soweit verlängert ist, daß sie den pn-Übergang zwischen 11 und 2 kurzschließt. Die Teile 11 und 12 bilden dann einen sog. Hilfsemitter (amplifying gate), der eine innere Zündverstärkung des Thyristors darstellt. Bei rotationssymmetrischem Aufbau des Thyristors ist die strichpunktierte Linie 13 als Symmetrieachse anzusehen. Mit la sind Ausnehmungen des n-Emitters 1 bezeichnet, die von entsprechenden Ansätzen 2a der p-Basis ausgefüllt werden. Letztere werden von der kathodenseitigen Elektrode 5 kontaktiert. Die Teile la und 2a bilden Emitter-Basis-Kurzschlüsse, die eine unerwünschte Zündung des Thyristors beim Anlegen von Blockierspannungen verhindern.

Zwischen der p-Basis 2 und der n-Basis 3 befindet sich ein pn-Übergang 14, der beim Anlegen einer Blockierspannung an die Anschlüsse A und K in Sperrichtung vorgespannt wird. Erhöht man die zwischen A und K liegende Blockierspannung auf den Wert der sog. Kippspannung, so führt der dann entstehende lokale Durchbruch des pn-Übergangs 14 zu einer unkontrollierbaren Zündung des Thyristors, die diesen thermisch zerstören kann.

Um diese Gefahr zu beseitigen, ist nach der Erfindung die Dotierungskonzentration des p-Emitters 4 innerhalb eines Teilbereichs 15 höher bemessen als in dem übrigen Teil des p-Emitters 4. Dabei liegt der Teilbereich 15 etwa unterhalb des Zündkontakts 8 bzw. bei konzentrischer Ausbildung des Thyristors im Bereich der Symmetrieachse 13, um eine möglichst schnelle Zündausbreitung zu gewährleisten. In Fig. 1 geht der Teilbereich 15 unmittelbar von der äußeren, von der anodenseitigen Elektrode 6 kontaktierten Grenzfläche 4a des p-Emitters 4 aus und hat eine Eindringtiefe, die kleiner ist als die Eindringtiefe des p-Emitters 4. Andererseits kann die Eindringtiefe des Teilbereichs 15 auch der des p-Emitters 4 entsprechen. Wichtig für das Verständnis der Erfindung ist es auch möglich, daß der Teilbereich 15 des p-Emitters 4 nicht bis an die Grenzfläche 4a heranreicht, sondern durch eine Teilschicht des p-Emitters 4 von dieser getrennt ist. Dieser Fall könnte in Fig. 1 durch eine Vertikalverschiebung des gestrichelt eingezeichneten Teilbereichs 15 nach oben angedeutet werden. Nimmt man beispielsweise an, daß bei einer Anordnung des Teilbereichs 15 gemäß Fig. 1 die Dotierungskonzentration des p-Emitters 4 an der Grenzfläche 4a zur anodenseitigen Elektrode 6 etwa 10¹⁸cm⁻³ beträgt, so wäre zweckmäßigerweise ein entsprechender Wert von 10²⁰cm⁻³ für den Teilbereich 15 vorzusehen. Durch die Erhöhung der Dotierungskonzentration innerhalb des Teilbereichs 15 wird eine Erhöhung des für die Schichtfolge 2, 3 und 4 im Bereich der Symmetrieachse 13 maßgebenden Verstärkungsfaktors βₚₙₚ erreicht, was eine Verringerung der Kippspannung auf den Wert einer reduzierten Kippspannung zur Folge hat. Mit Vorteil erfolgt die Erhöhung der Dotierungskonzentration im Teilbereich 15 im Wege einer Ionenimplantation, der sich ein Temperschritt anschließt. Unter diesem wird eine Erwärmung des Halbleiterkörpers auf etwa 950° bis 1200°C für eine vorgegebene Zeitspanne von z.B. 30 Minuten bis 30 Stunden verstanden.

In Figur 2 ist ein lichtzündbarer Thyristor dargestellt, bei dem anstelle der elektrischen Zündung mittels des Zündkontakts 8 eine Lichtzündung durch Bestrahlung einer etwa im Bereich der Symmetrieachse 13 liegenden lichtempfindlichen Thyristorzone 17a mit einem Lichtimpuls erfolgt. Der Lichtimpuls ist in Figur 2 mit 17 angedeutet. Zur Zuführung des Lichtimpulses wird im allgemeinen ein Lichtleiter verwendet, der insbesondere so ausgebildet sein kann, wie in der EP-A 0 197 512 im einzelnen beschrieben ist. Auch hier wird durch den Teilbereich 15 eine reduzierte Kippspannung eingestellt.

Bei der Herstellung eines erfindungsgemäßen Thyristors wird von einem schwach n-leitenden Halbleiterkörper 18 in Form einer flachen Scheibe ausgegangen, der in an sich bekannter Weise mit einer randseitigen p-Diffusionszone versehen wird, die sich bis zu den Linien 19 und 20 in den Halbleiterkörper hinein erstreckt . Nach dem Entfernen des Scheibenrandes bis auf die Seitenflächen 21 und 22 stellt der obere Teil der p-Diffusionszone die p-Basis 2 dar, während der untere Teil der p-Diffusionszone den p-Emitter 4 bildet. Nach dem Aufbringen einer Maske 23 aus SiO₂ oder lichtempfindlichem Lack wird auf fotolithografischem Wege ein Maskenfenster 24 vorgesehen, durch das in einem sich anschließenden, mit 25 angedeuteten Implantationsschritt Akzeptorionen mit einer Implantationsdosis von z.B. 10¹⁶cm⁻² eingebracht werden. In dem folgenden Temperschritt entsteht dann der höher dotierte Teilbereich 15 der p-Basis 4.

Bei einem Thyristor nach der Erfindung können die zur inneren Zündverstärkung dienenden Teile 11 und 12 auch entfallen.

## Patentansprüche

1. Thyristor mit einem Halbleiterkörper, der einen von einer kathodenseitigen Elektrode (5) kontaktierten n-Emitter (1) mit einer angrenzenden p-Basis (2) und einem von einer anodenseitigen Elektrode (6) kontaktierten p-Emitter (4) mit einer angrenzenden Basis (3) aufweist, die ihrerseits durch einen pn-Übergang (14) von der p-Basis (2) getrennt ist, und mit einem Teilbereich (15) des p-Emitters, der eine unterhalb eines Zündkontakts (8) oder einer lichtempfindlichen Thyristorzone (17a) angeordnet ist, der eine höhere p-Dotierungskonzentration aufweist als die übrigen Teile des p-Emitters (4) und der unmittelbar an die anodenseitige Elektrode (6) angrenzt,
**dadurch gekennzeichnet,**
daß die übrigen Teile des p-Emitters (4) eine Dotierungskonzentration von etwa 10¹⁸ cm⁻³ aufweisen.

2. Verfahren zur Herstellung eines Thyristors nach Anspruch 1, **dadurch gekennnzeichnet,** daß ausgehend von einem dotierten Halbleiterkörper mit vier aufeinanderfolgenden Halbleiterschichten alternierender Leitfähigkeitstypen, die einen n-Emitter (1), eine p-Basis (2), eine n-Basis (3) und einen p-Emitter (4) darstellen, eine fotolithografische Maske (23) auf der äußeren Grenzfläche (4a) des p-Emitters (4) aufgebracht und mit einem Fenster (24) versehen wird, daß durch dieses Fenster (24) in den p-Emitter (4) Akzeptorionen eingebracht werden und daß der Teilbereich (15) des p-Emitters (4) durch einen sich anschließenden Temperschritt gebildet wird.

## Claims

1. Thyristor having a semiconductor body which exhibits an n-emitter (1) contacted by a cathode-side electrode (5) with an adjoining p-base (2) and a p-emitter (4) contacted by an anode-side electrode (6) with an adjoining base (3), which for its part is separated from the p-base (2) by a pn-junction (14), and having a partial region (15) of the p-emitter which is disposed an below an ignition contact (8) or a light-sensitive thyristor zone (17a), exhibits a higher p-doping concentration than the remaining parts of the p-emitter (4) and directly adjoins the anode-side electrode (6), characterized in that the remaining parts of the p-emitter (4) exhibit a doping concentration of approximately 10¹⁸ cm⁻³.

2. Process for the production of a thyristor according to Claim 1, characterized in that, proceeding from a doped semiconductor body with four successive semiconductor layers of alternating conductivity types, which represent an n-emitter (1), a p-base (2), an n-base (3) and a p-emitter (4), a photolithographic mask (23) is applied to the outer boundary surface (4a) of the p-emitter (4) and is provided with a window (24), in that acceptor ions are introduced through this window (24) into the p-emitter (4) and in that the partial region (15) of the p-emitter (4) is formed by a subsequent annealing step.

## Revendications

1. Thyristor comprenant un corps semi-conducteur qui est pourvu d'un émetteur N (1) contacté par une électrode (5) située du côté de la cathode, avec une base P (2) contiguë, et d'un émetteur P (4) contacté par une électrode (6) située du côté de l'anode, avec une base (3) contiguë qui, pour sa part, est séparée de la base P (2) par une jonction PN (14), et comprenant une zone partielle (15) de l'émetteur P qui est située sous un contact d'amorçage (8) ou une zone photosensible (17a) du thyristor, laquelle zone partielle présente une concentration de dopage P plus élevée que les autres parties de l'émetteur P (4) et est directement contiguë à l'électrode (6) située du côté de l'anode, caractérisé en ce que les autres parties de l'émetteur P (4) ont une concentration de dopage à peu près égale à 10¹⁸ cm⁻³.

2. Procédé de fabrication d'un thyristor selon la revendication 1, caractérisé en ce que, à partir d'un corps semi-conducteur dopé comprenant quatre couches de semi-conducteur successives à types de conduction alternés qui représentent un émetteur N (1), une base P (2), une base N (3) et un émetteur P (4), un masque photolithographique (23) est appliqué sur la surface limite extérieure (4a) de l'émetteur P (4) et est pourvu d'une fenêtre (24), en ce que, à travers cette fenêtre (24), des ions accepteurs sont introduits dans l'émetteur P (4), et en ce que la zone partielle (15) de l'émetteur P (4) est formée grâce à une phase de cuisson consécutive.
